# EUROPEAN PATENT APPLICATION

(11) **EP 1 921 490 A1**
(43) Date of publication of application: **14.05.2008**
(21) Application number: 07021548.8
(22) Date of filing: 06.11.2007
(51) Int. Cl.: G02F 1/1333

(54) **Method of forming identification marks for a display substrate and a display device using the same**

(30) Priority: 10.11.2006 KR 20060110837
(71) Applicant: Samsung Electronics Co., Ltd., Yeongtong-gu Suwon-city, Gyeonggi-do 442-742 (KR)
(72) Inventor: Jeon, Ki-Hun, Seoul (KR); Yang, Yong-Ho, Suwon-si Gyeonggi-do (KR)
(74) Representative: Dr. Weitzel & Partner

(57) **Abstract**

A method of forming a cell identification (201) includes forming a metal layer on a substrate, coating a photoresist material on the metal layer to form a photoresist film, exposing the photoresist film through a mask including a light-blocking pattern corresponding to a cell identification pattern, developing an exposed photoresist film, etching the metal layer using a developed photoresist film to form a metal pattern including the cell identification pattern, and irradiating a laser beam onto a symbol of the cell identification pattern. Furthermore, a display region (180) and a peripheral region (185) are defined on the substrate. An image is displayed in the display region (180). The peripheral region (185) surrounds the display region (180).
The cell identification (201) formed in the peripheral region (185) includes the cell identification pattern and a mark (200) marked on the cell identification pattern. The cell identification pattern may be either a steady part (120) or a transient part (110). The steady part (120) is not changed during manufacturing processes. The transient part (110) is marked by the mark (200) during each of the manufacturing processes. The transient part (110) includes a plurality of cell identification arrays (101,103 and 105).

## Description

### BACKGROUND OF THE INVENTION

### 1. Field of the Invention

The present invention relates to a method of forming a cell Identification. More particularly, the present invention relates to a method of forming a cell identification, a display substrate having the cell identification and a display device having the cell Identification.

### 2. Description of Related Art

A liquid crystal display (LCD) device has a cell identification, which may be used to track a history of an LCD panel, The cell identification is needed to analyze defects of the LCD panel and to follow up for after-sales service.

Typically, two to eight cell identifications are used on a motherboard for large screen LCD panels. In the process of manufacturing the LCD panel, a time for forming the cell identifications is short compared with a time for exposing a photoresist film. The number of cell identifications on a motherboard for small screen LCD panels may range from tens to hundreds, so that a tack time of the LCD panel is increased by a time for forming the cell identifications. As the size of the motherboard has increased, the time for forming the cell identifications has increased,

In order to decrease the tack time, formation of the cell identifications is omitted. When the forming of the cell identifications is omitted, defects of the LCD panel are not easily analyzed and the LCD panel's history is difficult to track for after-safes service purposes.

Therefore, a need exists for a method of forming a cell identification, which is capable of improving productivity.

### SUMMARY OF THE INVENTION

A method of forming a cell identification in accordance with an embodiment of the present invention includes forming a metal layer on a substrate, and coating a photoresist material on the metal layer to form a photoresist film, exposing the photoresist film through a mask including a light-blocking pattern corresponding to a cell identification pattern, developing an exposed photoresist film, etching the metal layer using a developed photoresist film to form a metal pattern including the cell identification pattern, and irradiating a laser beam onto a symbol of the cell identification pattern.

A method of forming a cell identification In accordance with another embodiment of the present invention includes coating a photoresist material on a substrate to form a photoresist film, exposing the photoresist film through a mask including a reticle corresponding to a cell identification pattern, developing an exposed photoresist film, depositing a metal layer on a developed photoresist film, removing the developed photoresist film to form a metal pattern including the cell identification pattern, and irradiating a laser beam onto a symbol of the cell identification pattern.

A display substrate in accordance with still another embodiment of the present invention includes a base substrate and a cell identification. The base substrate has a display region and a peripheral region, the display region for displaying an Image. The cell identification is formed in the peripheral region, and includes a cell array including a plurality of symbols, and a mark marked on at least one of the symbols of the cell array.

A display device in accordance with still another embodiment of the present invention includes a base substrate, a cell identification, an opposite substrate and a liquid crystal layer. The base substrate has a display region and a peripheral region, the display region for displaying an image. The cell identification is formed in the peripheral region, and includes a cell array including a plurality of symbols, and a mark marked on at least one of the symbols of the cell array. The opposite substrate is combined with the display substrate. The liquid crystal layer is interposed between the base substrate and the opposite substrate.

### BRIEF DESCRIPTION OF THE DRAWINGS

The present invention will become more apparent by describing in detail example embodiments thereof with reference to the accompanying drawings, in which;
FIG. 1 is a plan view illustrating a cell identification in accordance with one exemplary embodiment of the present invention;
FIG, 2 is an enlarged plan view illustrating the cell identification shown in FIG. 1;
FIG. 3A is a plan view illustrating a display substrate including a cell identification pattern in accordance with another exemplary embodiment of the present invention;
FIG. 3B is a plan view illustrating a display substrate including a mark formed on the cell identification pattern shown in FIG. 3B;
FIG. 4 is a cross-sectional view illustrating a display device in accordance with one exemplary embodiment of the present invention;
FIGS. 5 to 7 are cross-sectional views illustrating a method of forming the cell identification shown in FIG. 4; and
FIGS. 8 to 10 are cross-sectional views illustrating a method of forming a cell identification in accordance with another exemplary embodiment of the present invention.

### DETAILED DESCRIPTION OF EXEMPLARY EMBODIMENTS

The invention is described more fully hereinafter with reference to the accompanying drawings, in which embodiments of the invention are shown, This invention may, however, be embodied In many different forms and should not be construed as limited to embodiments set forth herein. Rather, embodiments are provided so that this disclosure will be thorough and complete, and will fully convey the scope of the invention to those skilled in the art. In the drawings, the size and relative sizes of layers and regions may be exaggerated for clarity.

Hereinafter, the present invention will be described in detail with reference to the accompanying drawings.

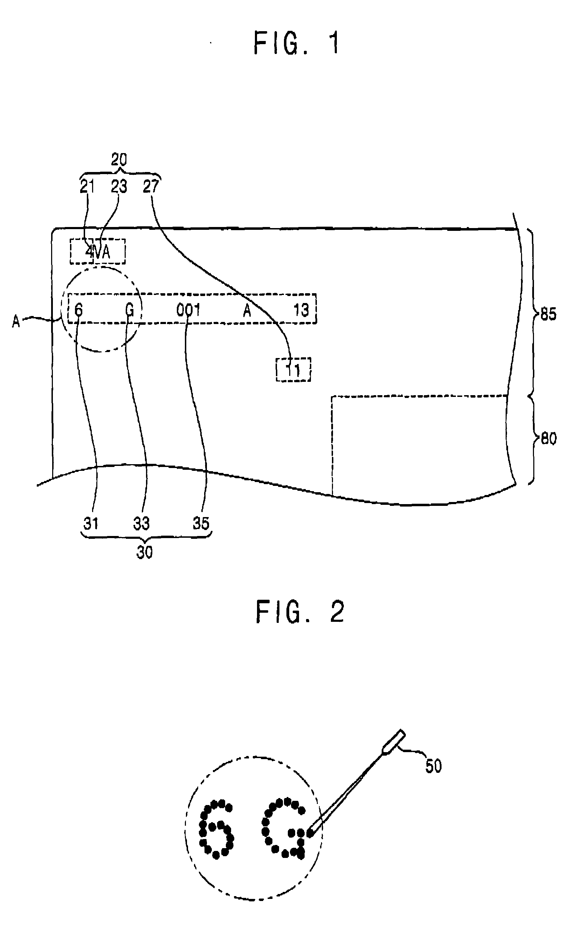

FIG, 1 is a plan view illustrating a cell identification in accordance with one exemplary embodiment of the present invention, FIG. 2 is an enlarged plan view illustrating the cell identification shown in FIG. 1.

Referring to FIGS. 1 and 2, a display region 80 and a peripheral region 85 are defined on a substrate. An image is displayed in the display region 80. The peripheral region 85 surrounds the display region 80.

Cell identifications 20 and 30 are disposed in the peripheral region 85, and include information about a manufacturing line 21, a brand 23, a year 31 of manufacturing, a month 33 of manufacturing, the number 35 of manufactured units, a position 27 of a cell on a motherboard, etc. The information of the manufacturing line 21, the brand 23 and the position 27 of the cell on the motherboard are a steady part 20 that is not changed during manufacturing processes. The steady part 20 may be formed through an automated photolithography process.

The Information of the year 31 of manufacturing, the month 33 of manufacturing and the number 35 of the manufactured units are a transient part 30 that is changed during the manufacturing processes, e.g., different among different substrates. In FIGS. 1 and 2, the transient part 30 is formed by a laser 50 during each of the manufacturing processes.

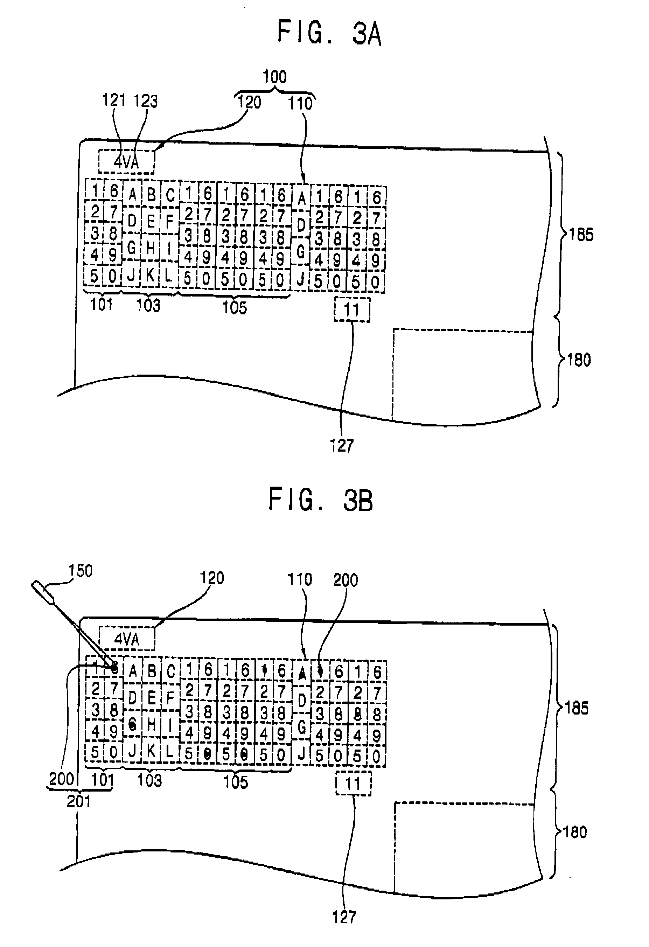

FIG. 3A is a plan view illustrating a display substrate including a cell identification pattern in accordance with another exemplary embodiment of the present Invention, FIG. 3B is a plan view illustrating a display substrate including a mark formed on the cell identification pattern shown in FIG. 3B.

Referring to FIGS, 3A and 3B, a display region 180 and a peripheral region 185 are defined on a substrate. An image is displayed In the display region 180. The peripheral region 185 surrounds the display region 180.

A cell identification 201 formed in the peripheral region 185 includes a cell identification pattern 100 and a mark 200 marked on the cell identification pattern 100,

The cell identification pattern 100 may be either a steady part 120 or a transient part 110. The steady part 120 is not changed during manufacturing processes. The transient part 110 is marked by the mark 200 during each of the manufacturing processes.

The steady part 120 displays information about a manufacturing line 121, a brand 123, a position 127 of a cell in a motherboard (not shown), etc.

The transient part 110 includes a plurality of cell identification arrays 101, 103 and 105, For example, the transient part 110 may include a cell identification array 101 corresponding to a year of manufacturing, a cell identification array 103 corresponding to a month of manufacturing, a cell identification array 105 corresponding to the number of manufactured units, etc.

Each of the cell identification arrays 101, 103 and 105 includes a total range of values needed for each part of the cell identification. For example, the cell identification array 101 corresponding to the year of manufacturing may include a plurality of symbols such as numbers, which covers all possible years of manufacturing, In another example, the cell identification array 103 corresponding to the month of manufacturing includes twelve characters corresponding to twelve months.

A laser beam generated from a laser 150 is irradiated onto a corresponding one of the symbols of each of the cell identification arrays 101, 103 and 105 during a corresponding manufacturing process, so that the mark 200 Is formed on the corresponding symbol of each of the cell Identification arrays 101, 103 and 105. Thus, the cell identification 201 including the cell identification pattern 100 and the mark 200 is formed. For example, the cell identification 201 may correspond to symbols of '6-G-001-A-13'.

The cell identification pattern 100 may be formed in the peripheral region 185 of the substrate, which is a non-display region, The cell Identification pattern 100 may be formed though various metal patterning methods. The cell identification pattern 100 may be formed from the same layer as a gate metal pattern in the display region 180. The cell identification pattern 100 may be formed from the same layer as a data metal pattern in the display region 180. The cell identification pattern 100 may be formed from various layers through various methods.

In FIGS. 1 and 2, the steady part 20 may be simultaneously formed through a photolithography process for forming the gate metal layer. However, all of the symbols of the transient part 30 may be formed using the laser 50 during each of the manufacturing processes, so that manufacturing time may be increased.

In FIGS, 3A and 3B, the transient part 190 of the cell Identification 201 is formed by marking the mark 200 using, for example, a dot on each of the cell identification arrays 101, 103 and 105. Therefore, the manufacturing time may be decreased.

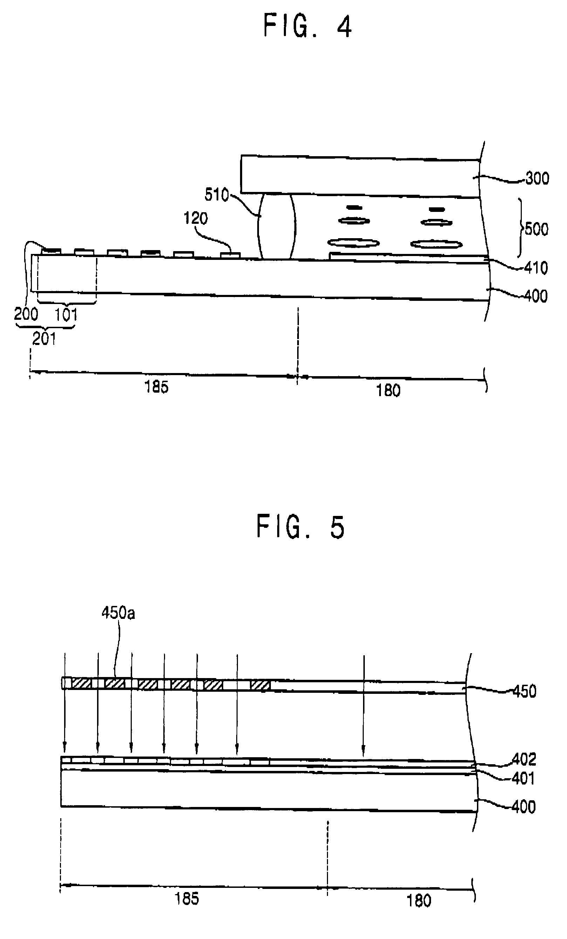

FIG. 4 is a cross-sectional view illustrating a display device in accordance with one exemplary embodiment of the present invention.

Referring to FIG. 4, the display device includes a base substrate 400, a cell identification 201, an opposite substrate 300, a sealant 510 and a liquid crystal layer 500.

The cell identification 201 of FIG. 4 is substantially the same as that in FIGS. 3A and 3B. Thus, the same reference numerals will be used to refer to the same or like parts as those described in FIGS, 3A and 3B and any further explanation concerning the above elements will be omitted.

A pixel array 410 is formed in a pixel region 180 of the base substrate 400. The pixel array 410 includes a plurality of thin-film transistors (TFT) (not shown), gate and data lines (not shown) electrically connected to the TFTs and a plurality of pixel electrodes (not shown) electrically connected to the TFTs, respectively.

The base substrate 400, the cell identification 201 and the pixel array 410 form a display substrate.

The opposite substrate 300 is combined with the base substrate 400, and faces the base substrate 400.

The liquid crystal layer 500 is interposed between the base substrate 400 and the opposite substrate 300, Liquid crystals of the liquid crystal layer 500 vary arrangement in response to an electric field applled thereto, and light transmittance of the liquid crystal layer 500 is changed, thereby displaying an image.

The sealant 510 surrounds sides of the base substrate 400 and the opposite substrate 300 to seal the liquid crystal layer 500.

FIGS. 5 to 7 are cross-sectional views illustrating a method of forming the cell identification shown in FIG. 4.

Referring to FIG. 5, a metal layer 401 is deposited on a base substrate 400 through a sputtering process.

A photoresist material Is coated on the metal layer 401 to form a photoresist film 402.

The photoresist film 402 is exposed through a mask having a light-blocking pattern 450a corresponding to a cell identification pattern. For example, the photoresist film 402 may include a positive photoresist material, and the light-blocking pattern 450a includes an opaque portion that blocks light.

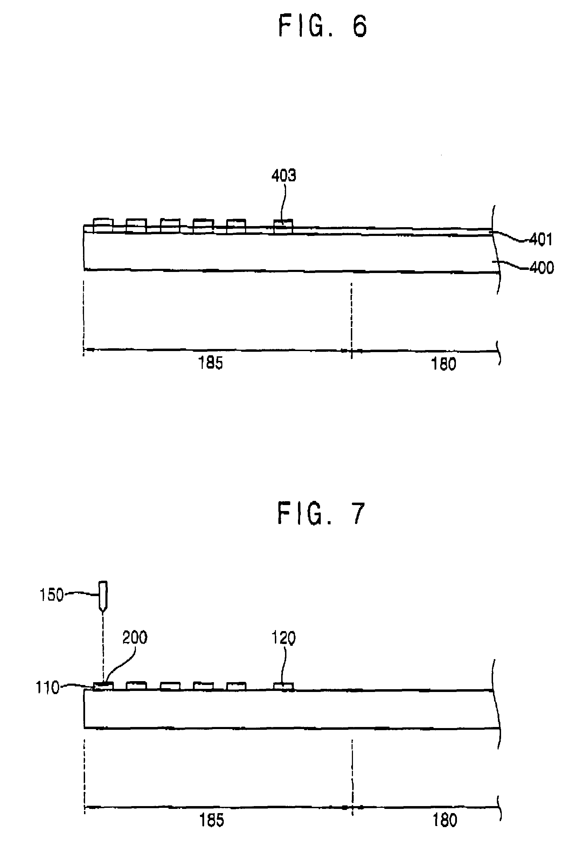

Referring to FIG. 6, the exposed photoresist film 402 is developed to form a photoresist pattern 403 on the metal layer 401.

Referring to FIG. 7, the metal layer 401 (shown in FIG, 6) is etched using the photoresist pattern 403 as an etching mask to form a metal pattern including the cell identification pattern 110 and 120.

The cell identification pattern 110 and 120 includes a transient part 110 and a steady part 120. The transient part 110 is changed during manufacturing processes, The steady part 120 is not changed during the manufacturing processes, The photoresist pattern 403 is then removed from the cell identification pattern 110 and 120.

A laser beam generated from a laser 150 is irradiated onto a corresponding symbol of the transient part 110 that corresponds to one of the manufacturing processes. Thus, the transient part 110 is marked by a mark 200 during the manufacturing processes.

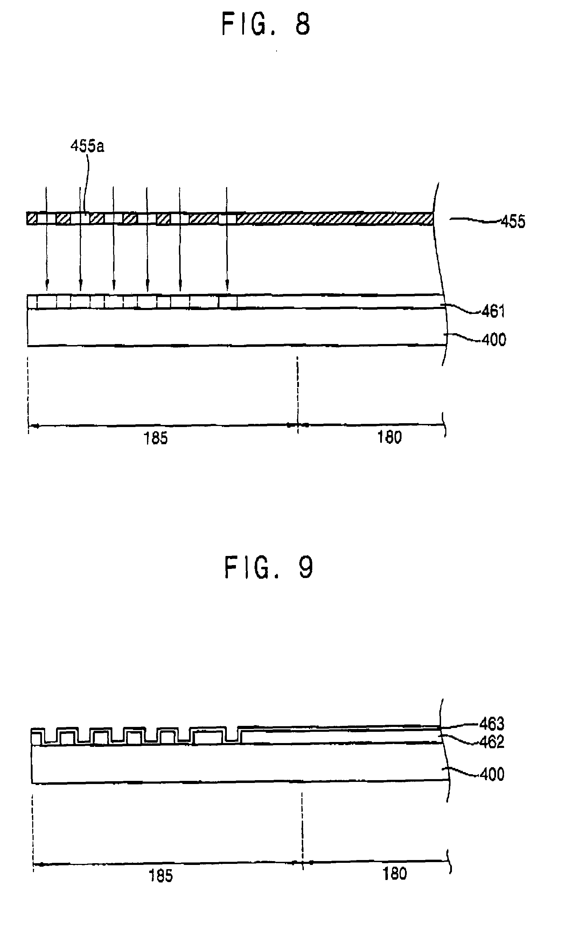

FIGS. 8 to 10 are cross-sectional views illustrating a method of forming a cell identification in accordance with another exemplary embodiment of the present invention,

Referring to FIG. 8, a photoresist material is coated on a base substrate 400 to form a photoresist film 461.

The photoresist film 461 is exposed through a mask having a reticle 455a corresponding to a cell identification pattern, For example, the photoresist film 461 may include a negative photoresist material, and the reticle 455a may Include a transparent portion that transmits light.

Referring to FIG. 9, the exposed photoresist film 461 (shown in FIG. 8) is developed to form a photoresist pattern 462 on the base substrate 400. in FIG. 9, an etching process for etching an underlying layer that Is disposed under the photoresist pattern 462 may be adjusted to form an undercut (not shown) under the photoresist pattern 462. The underlying layer may be a conductive pattern (not shown), an inorganic insulating pattern (not shown), etc. Alternatively, the photoresist pattern 462 may be ashed to form recesses (not shown) on an upper surface of the photoresist pattern 462.

A metal layer 463 is deposited on the photoresist pattern 462 through a sputtering process.

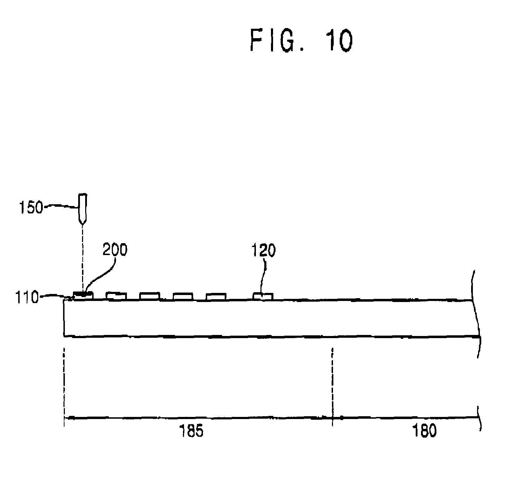

Referring to FIG. 10, the photoresist pattern 462 is removed using a developing agent so that the metal layer 463 on the photoresist pattern 462 is lifted off. In FIG, 10, the developing agent permeates into the photoresist pattern 462 through the undercut. Thus, a metal pattern including the cell identification pattern 110 and 120 is formed.

A laser beam generated from a laser 150 Is irradiated onto a corresponding symbol of the transient part 110 that corresponds to one of the manufacturing processes. Thus, the transient part 110 is marked by a mark 200 during the manufacturing processes.

According to the present invention, manufacturing time may be decreased, and productivity may be improved. Also, the number of cell identifications may not be decreased.

This invention has been described with reference to exemplary embodiments. It is evident, however, that many alternative modifications and variations will be apparent to those having skill in the art in light of the foregoing description. Accordingly, the present invention embraces all such alternative modifications and variations as fall within the spirit and scope of the disclosure.

## Claims

1. A method of forming a cell identification, comprising:
depositing a metal on a substrate to form a metal layer;
coating a photoresist material on the metal layer to form a photoresist film;
exposing the photoresist film through a mask including a light-blocking pattern corresponding to a cell identification pattern;
developing the exposed photoresist film;
etching the metal layer using the developed photoresist film to form a metal pattern including the cell identification pattern; and
irradiating a laser beam onto a symbol of the cell identification pattern.

2. The method of claim 1, further comprising removing the photoresist film.

3. The method of claim 1, wherein the cell identification pattern comprises a cell array.

4. The method of claim 1, wherein the cell identification pattern comprises a plurality of cell arrays, and the cell arrays correspond to a year of manufacturing, a month of manufacturing and the number of manufacturing units, respectively,

5. A method of forming a cell identification, comprising:
coating a photoresist material on a substrate to form a photoresist film;
exposing the photoresist film through a mask including a reticle corresponding to a cell identification pattern;
developing the exposed photoresist film;
depositing a metal on the developed photoresist film to form a metal layer;
removing the developed photoresist film to form a metal pattern Including the cell identification pattern; and
irradiating a laser beam onto a symbol of the cell identification pattern.

6. A display substrate comprising:
a base substrate having a display region and a peripheral region, the display region for displaying an image; and
a cell identification in the peripheral region, the cell identification including:
a cell array including a plurality of symbols; and
a mark marked on at least one of the symbols of the cell array.

7. The display substrate of claim 6, wherein the cell identification comprises a transient part having transient information that is changed during manufacturing processes among different display substrates.

8. The display substrate of claim 7, wherein the cell identification comprises a steady part having steady Information that is not changed during the manufacturing processes among different display substrates.

9. The display substrate of claim 6, further comprising a pixel array In the display region to display the image.

10. A display substrate comprising:
a base substrate having a display region and a peripheral region, the display region for displaying an image;
a cell identification in the peripheral region, the cell identification including a cell array including a plurality of symbols, and a mark marked on at least one of the symbols of the cell array;
an opposite substrate combined with the display substrate; and
a liquid crystal layer interposed between the base substrate and the opposite substrate.

11. The display substrate of claim 10, wherein the cell array comprises a metal pattern.
